# EUROPEAN PATENT SPECIFICATION

(11) **EP 0 549 080 B1**
(45) Date of publication and mention of the grant of the patent: **18.09.1996**
(21) Application number: 92204081.1
(22) Date of filing: 23.12.1992
(51) Int. Cl.: C08L 63/00, C08G 59/20, B32B 27/38

(54) **Epoxy resin composition**
Epoxydharzzusammensetzung
Composition de résine époxy

(30) Priority: 27.12.1991 JP 358340/91
(43) Date of publication of application: 30.06.1993
(73) Proprietor: SHELL INTERNATIONALE RESEARCH MAATSCHAPPIJ B.V., NL-2596 HR Den Haag (NL)
(72) Inventor: Maeda, Kazuo, c/o Yuka Shell Epoxy KK, Dept.ADMP, 4-chome, Minato-Ku,Tokyo 106 (JP); Watanabe, Takao, c/o Yuka Shell Epoxy KK,Dept.ADMP, 4-chome, Minato-ku, Tokyo 106 (JP); Fukuzawa, Takao, c/o Yuka Shell Epoxy KK,Dept.ADMP, 4-chome, Minato-ku, Tokyo 106 (JP)

(56) References cited:
- US-A- 3 514 418
- DATABASE WPIL Week 8449, Derwent Publications Ltd., London, GB; AN 84-305021

## Description

The present invention relates to an epoxy resin and an epoxy resin composition comprising this epoxy resin. The epoxy resin composition of the invention is particularly useful for the production of copper-clad epoxy resin laminates for printed circuit boards (PCB's), especially multi-layered PCB's, due to its good impregnation into glass cloth and good prepreg stability, and its ability to provide to the cured laminate product good heat resistance, good measling resistance, good drillability, and good adhesion to metal.

The recent trend to miniaturization of electronic machines and equipment has roused the need for more densely patterned PCB's. As a consequence thereof substrates having improved heat resistance and measling resistance are required.

It is known that epoxy resins having improved heat resistance can be obtained by reacting a polyhydric phenolic compound with a bisphenol-type epoxy resin and any compound selected from the group consisting of phenol novolak-type epoxy resins, bisphenol A novolak-type epoxy resins, and cresol novolak-type epoxy resins. However, these epoxy resins contain a relatively large amount of high molecular weight components, which results in a high resin viscosity and which in its turn has a negative effect on the ability of the resin to impregnate glass cloth and in particular on the stability of prepregs prepared with this resin.

Moreover cured laminates prepared with these known heat resistant epoxy resins show insufficient soldering resistance (measling resistance) and are hard and brittle which negatively affects their drillability.

It is an object of the present invention to provide an epoxy resin and an epoxy resin composition comprising this epoxy resin, the latter showing improved impregnation into glass cloth and improved prepreg stability and being particularly suitable for the production of copper-clad epoxy resin laminates for printed-circuit boards which, in the cured state, show good heat resistance, good drillability, good adhesion to copper foil and in particular good measling resistance.

Therefore the present invention relates to an epoxy resin comprising as principal component an "epoxy resin a" which has a polydispersity coefficient, (M_{w}/Mₙ), lower than 2.5 and which is obtainable by reacting:
1. a polyglycidyl-etherified product (I), obtainable by glycidyletherifying a polyfunctional phenolic compound selected from the group consisting of:
   (1) a product being obtainable by reacting an aldehyde compound or ketone compound having a hydroxyl group-substituted phenyl group with a phenolic compound in the presence of an acid catalyst, (2) a product being obtainable by reacting a phenol dimethylol compound or a phenol novolak dimethylol compound with a phenolic compound in the presence of an acid catalyst, and (3) a product obtainable by reacting a phenolic compound with formaldehyde in the presence of an acid catalyst with
2. a difunctional epoxy resin (II), having the skeleton of at least one bisphenol compound selected from the group consisting of bisphenol A, bisphenol F and tetrabromobisphenol A, and with
3. at least one bisphenol compound (III), selected from the group consisting of bisphenol A, bisphenol F and tetrabromobisphenol A.

The aldehyde compound or ketone compound having a hydroxyl group-substituted phenyl group, used for the preparation of the above-mentioned compound (1) is for example salicylaldehyde, p-hydroxybenzaldehyde, and p-hydroxy-acetophenone.

The phenolic compound used for the preparation of the above-mentioned compounds (1), (2), and (3) is for example phenol, o-cresol, m-cresol, p-cresol, p-(t-butyl)-phenol, or bisphenol A.

The phenol dimethylol compound or phenol novolak dimethylol compound used for the preparation of the above-mentioned compound (2) is for example an o-cresoldimethylol compound, a p-cresoldicompound, a dimethylolphenol compound, or a phenol binuclear dimethylol compound represented by the following formula (A): 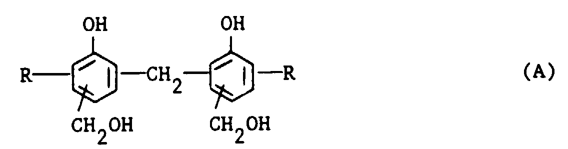 wherein each R is independently H or CH₃.

Examples of such compounds A are an o-cresol binuclear dimethylol compound, a m-cresol binuclear dimethylol compound, a p-cresol binuclear dimethylol compound, and a phenol binuclear dimethylol compound.

For the preparation of the polyglycidyl-etherified product (I) any one of the above-mentioned polyfunctional phenolic compounds (1), (2), and (3) is glycidyl-etherified by reaction with epichlorohydrin or epibromohydrin according to known methods in the art.

The above epoxy resin (II) and the bisphenol compound (III) are well known in the art and readily commercially available. Therefore detailed descriptions thereof are not given.

For the preparation of "epoxy resin a", the reaction between the polyglycidyl-etherified product (I), the difunctional epoxy resin (II), and bisphenol compound (III) is preferably carried out in the presence of a reaction catalyst, usually at a temperature of from 100-200 °C for a period of time of from 60-200 minutes.

Catalysts which can be employed in the above reaction include imidazoles (such as 1,2-dimethylimidazole and 2-methylimidazole), amines (such as trimethylamine and triethylamine), ammonium salts (such as tetramethylammonium bromide and tetramethylammonium chloride), phosphines (such as triphenylphosphine), and phosphonium salts (such as benzyltriphenyl phosphonium chloride and ethyltriphenyl phosphonium bromide).

The "epoxy resin a" prepared as described above has a polydispersity coefficient (M_{w}/Mₙ) of molecular weight distribution lower than 2.5, has a low viscosity and hence provides good impregnation into glass cloth and prepreg stability. A polydispersity coefficient (M_{w}/Mₙ) of molecular weight distribution higher than 2.5, results in a relatively poor impregnation into glass cloth and a relatively poor prepreg stability, due to the presence of a relatively large amount of high-molecular weight components.

The epoxy resin of the present invention may comprise "epoxy resin a" alone or in combination with other epoxy resins having two or more epoxy groups per molecule. Examples of such a polyfunctional epoxy resins include glycidyl ether-type epoxy resins (such as bisphenol A-type epoxy resins, phenol novolak-type epoxy resins, and cresol novolak-type epoxy resins), glycidyl ester-type epoxy resins, glycidyl amine-type epoxy resins, linear aliphatic epoxy resins, alicyclic epoxy resins, heterocyclic epoxy resins and halogenated epoxy resins. These polyfunctional epoxy resins, should be used in an amount of less than 50 parts by weight per 100 parts by weight of the total amount of the "epoxy resin a" and the polyfunctional epoxy resin(s) to be used in combination with it, which is inter alia of importance for obtaining a good quality of laminates containing this resin blend.

The present invention further relates to an epoxy resin composition comprising the epoxy resin of the invention as discussed above, a hardener an accelerator and a solvent. The hardener used in the composition of the present invention can be selected from a group including the aromatic polyamines, dicyandiamide, the acid anhydrides, and the phenol novolak resins.

The epoxy resin composition also comprises an accelerator, which can be selected from a group including benzyldimethylamine, the amines (such as imidazole compounds), and the tertiary phosphines (such as triphenylphosphine).

The solvent used in the composition of the present invention can be selected from a group including acetone, methyl ethyl ketone, toluene, xylene, methyl isobutyl ketone, ethyl acetate, ethylene glycol monomethyl ether, N,N-dimethylformamide, N,N-dimethylacetamide, methanol and ethanol. These solvents may be used alone or in combination with one another.

Optionally the epoxy resin composition according to the present invention may further comprise other additives such as flame retardants and fillers.

As already pointed out above the epoxy resin composition of the present invention is particularly useful for the production of copper-clad epoxy resin laminates. This process is known in the art and essentially consists of impregnating the glass cloth with the epoxy resin composition and converting the composite material into a prepreg by heating and drying in order to remove the solvent and laminating one or more sheets of the prepreg with copper foil on one side or both sides of said laminate while heating and pressurizing.

### EXAMPLES

In the following examples and comparative example, quantities are expressed in terms of "parts" for parts by weight and "%" for percent by weight. The examples are not intended to restrict the scope of the invention.

### Example 1

### Production of polyglycidyl-etherified products (I)

i) A glass vessel equipped with a stirrer was charged with 168 g of 2,4-bishydroxymethyl-o-cresol, 324 g of o-cresol, and 2 g of oxalic acid. After reaction at 75 °C for 4 hours, the reaction product was dehydrated under reduced pressure and steam distilled for the removal of unreacted o-cresol. 330 g of polyfunctional phenol compound was thus obtained.
   116 g of this polyfunctional phenol compound and 595 g of epichlorohydrin were placed in a glass vessel equipped with a stirrer. The reactants were heated from 30 °C to 50 °C at a rate of 1 °C/3 minutes. During the heating period, a 48.5% aqueous solution of NaOH was added dropwise at a rate of 1 g/2 minutes. When the temperature reached 50 °C, reaction was carried out at 50 °C for 60 minutes. After the reaction was complete, epichlorohydrin was removed from the reaction product under reduced pressure and then washed with water. 169 g of the polyglycidyl-etherified product "i" was thus obtained having an epoxy equivalent of 190 g/eq.
ii) The reaction- and post treatment procedure as presented under i) was repeated, except that the 2,4-bishydroxymethyl-o-cresol component was replaced by 290 g of bis(2-hydroxy-5-hydroxymethyl-3-methylphenyl)methane. 440 g of polyfunctional phenol compound was thus produced. 118 g of this polyfunctional phenol compound was used as in i) to prepare 170 g of the polyglycidyl-etherified product "ii" having an epoxy equivalent of 195 g/eq.
iii) A glass vessel equipped with a stirrer was charged with 228 g of bisphenol A, 61 g of 37% formalin, and 1.3 g of oxalic acid. After reaction at 130 °C for 180 minutes, the reaction product was dehydrated under reduced pressure. 240 g of polyfunctional phenol compound was thus obtained.

118 g of this polyfunctional phenol compound was used as in i) to prepare 167 g of the polyglycidyl-etherified product "iii" having an epoxy equivalent of 193 g/eq.

### Example 2

### Preparation of epoxy resin compositions of invention and use thereof for preparation of copper clad epoxy resin laminates

iv) 20 parts of the polyglycidyl-etherified product "i", 46 parts of bisphenol A-type epoxy resin, "Epikote 828" having an epoxy equivalent of 193 g/eq. (Epikote is a tradename), and 34 parts of tetrabromobisphenol A were reacted at 150 °C for 180 minutes in the presence of 0.03 part of the catalyst 1,2-dimethylimidazole to give an epoxy resin "iv" having an epoxy equivalent of 448 g/eq. and a polydispersity coefficient of molecular weight distribution of 1.7.
   A mixture of 100 parts of epoxy resin "iv", 3 parts of dicyandiamide as a hardener and 0.15 parts of 2-ethyl-4-methylimidazole as an accelerator was 1:1 (by weight) diluted with a solvent blend of methyl ethyl ketone and ethylene glycol monomethyl ether to give a varnish having a solids content of 55 wt%.
   A glass cloth was impregnated with this varnish. After drying the glass cloth at 130 °C for 7 minutes, a prepreg was obtained having an epoxy resin solids content of 45%. Eight sheets of the prepreg were stacked and the top and bottom surfaces were each covered with a sheet of copper foil of 35 µm thickness. This assembly was pressed at 40 kg/cm² and 170 °C. A 1.6 mm thick copper-clad glass epoxy laminate was thus obtained.
v) 15 Parts of polyglycidyl-etherified product "ii", 51 parts of Epikote 828, and 34 parts of tetrabromobisphenol A were reacted in the same manner as under iv) to prepare an epoxy resin "v" having an epoxy equivalent of 445 g/eq. and a polydispersity coefficient of molecular weight distribution of 2.0.

A varnish and a copper-clad glass epoxy laminate were prepared using epoxy resin "v" in the same manner as example 2 iv). vi) 30 Parts of polyglycidyl-etherified product "iii", 34 parts of Epikote 828, 11 parts of brominated bisphenol-type epoxy resin ("Epikote 5050" having an epoxy equivalent of 390 g/eq. and containing 49% bromine), and 25 parts of tetrabromobisphenol A were reacted in the same manner as under iv) to prepare an epoxy resin "vi" having an epoxy equivalent of 385 g/eq. and a polydispersity coefficient of molecular weight distribution of 1.9.

A varnish and a copper-clad glass epoxy laminate were prepared using epoxy resin "vi" in the same manner as in example 2 iv).

### Comparative Example 1

vii) 30 Parts of bisphenol A novolak-type epoxy resin ("Epikote 157S70" having an epoxy equivalent of 208 g/eq.), 36 parts of Epikote 828 and 34 parts of tetrabromobisphenol A were reacted in the same manner as under iv) to prepare an epoxy resin "vii" having an epoxy equivalent of 482 g/eq. and a polydispersity coefficient of molecular weight distribution of 3.3.

A varnish and a copper-clad glass epoxy laminate were prepared using epoxy resin "vii" in the same manner as in example 2 iv).

### Analysis methods

The methods used to measure the polydispersity coefficient of molecular weight distribution and to test the storage stability of the prepreg are the following:
(1) Measurement of polydispersity coefficient of molecular weight distribution:
   The number-average molecular weight (Mₙ) and the weight-average molecular weight (M_{w}) of the sample was determined by gel permeation chromatography (GPC) using four columns in series, one TSK gel G400 Hx1, two TSK gel G3000 Hx1, and one TSK gel G2000 Hx1, all manufactured by Toso Co., Ltd., and using tetrahydrofuran (THF) as the solvent. The ratio M_{w}/Mₙ is the polydispersity coefficient.
(2) Test for storage stability of prepreg:
   The gel time of the prepreg was measured initially and after storage at 40 °C for 14 days and gel time retention in respect of the initial value was calculated.

Table 1 shows the physical properties of the resin compositions prepared in examples 2 iv), v) and vi) and in comparative example 1 vii) ( without solvent) before curing and the physical properties of the cured laminates.

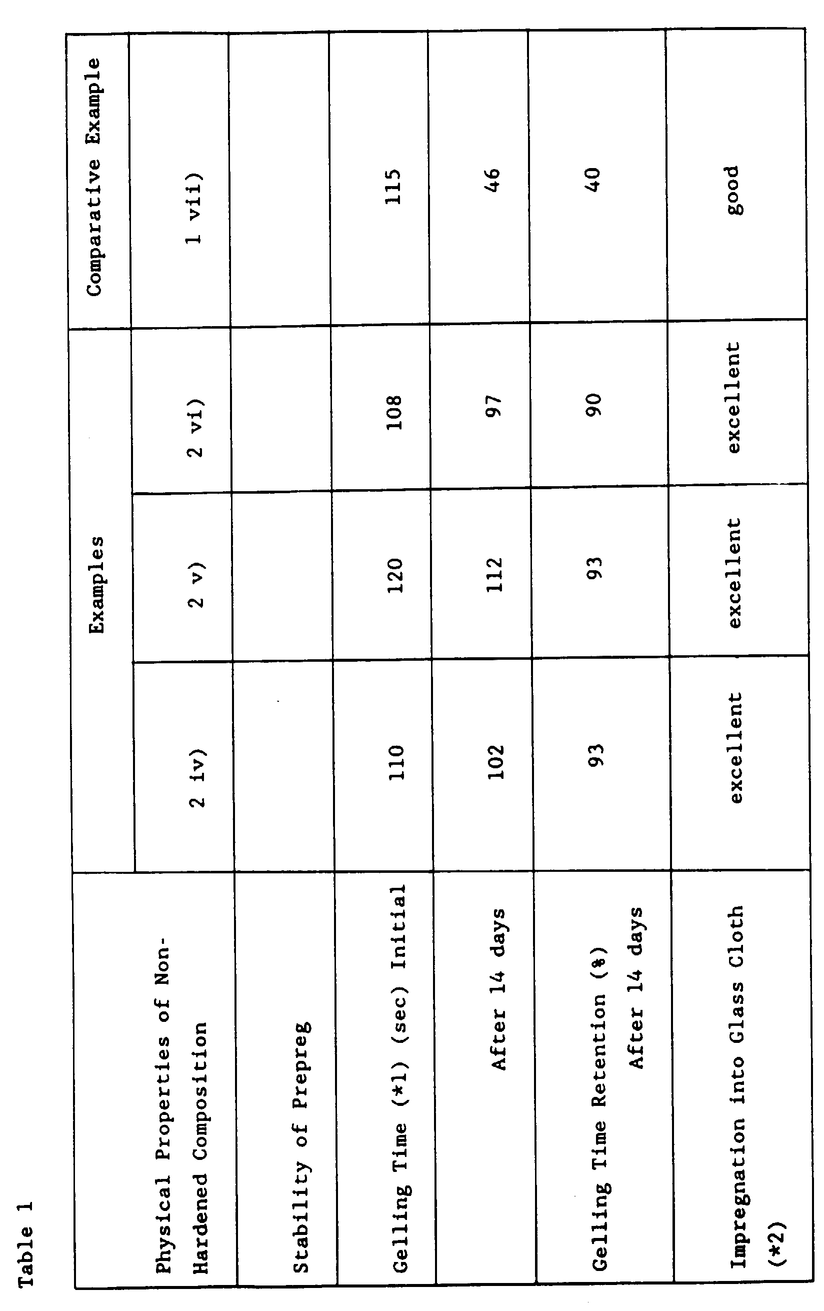

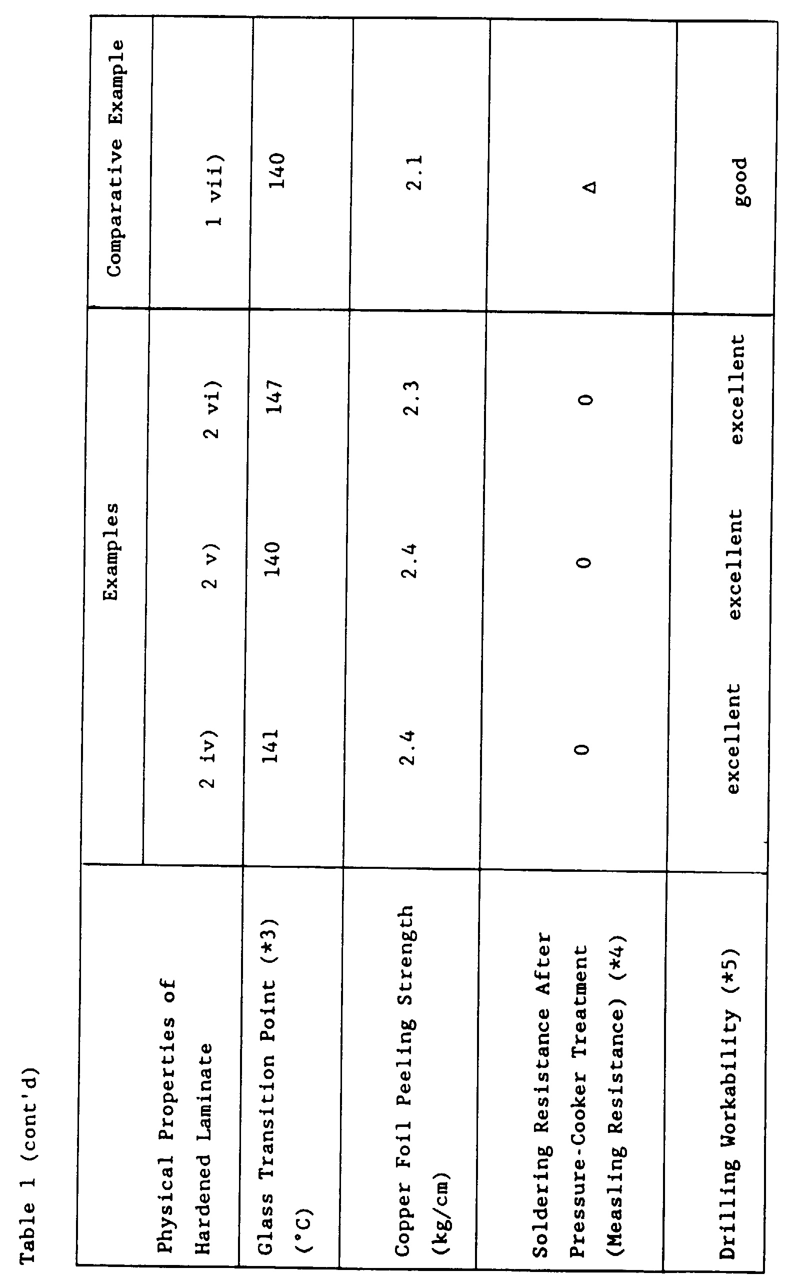

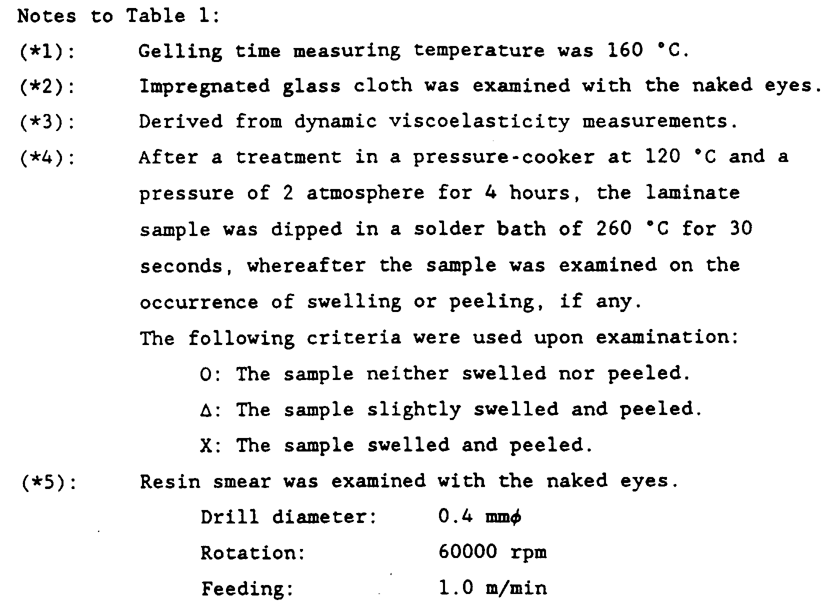

From Table 1 it follows that the epoxy resin compositions of the examples according to the invention show well-balanced and good glass cloth impregnatability and prepreg stability, when compared to epoxy resin composition according to comparative example 1 vii). In addition, the epoxy resin compositions according to the invention give excellent hardened laminates each having well-balanced and good heat resistance, measling resistance, drilling workability and copper foil adhesiveness, when compared with a laminate comprising the epoxy resin composition according to comparative example 1 vii).

## Claims (Claims for the following Contracting State(s): AT, BE, DE, FR, GB, IT, NL)

1. An epoxy resin comprising as principal component an "epoxy resin a" which has a polydispersity coefficient, (M_{w}/Mₙ), lower than 2.5 and which is obtainable by reacting:
1. a polyglycidyl-etherified product (I), obtainable by glycidyletherifying a polyfunctional phenolic compound selected from the group consisting of bisphenol A, bisphenol F and tetrabromobisphenol A. selected from the group consisting of:
(1) a product being obtainable by reacting an aldehyde - or ketone compound having a hydroxyl group substituted phenyl group with a phenolic compound in the presence of an acid catalyst;
(2) a product being obtainable by reacting a phenol dimethylol compound or a phenol novolak dimethylol compound with a phenolic compound in the presence of an acid catalyst; and
(3) a product obtainable by reacting a phenolic compound and formaldehyde in the presence of an acid catalyst, with
2. a difunctional epoxy resin (II), having the skeleton of at least one bisphenol compound selected from the group consisting of bisphenol A, bisphenol F and tetrabromobisphenol A, and with
3. at least one bisphenol compound (III), selected from the group consisting of bisphenol A, bisphenol F and tetrabromobisphenol A.

2. An epoxy resin as claimed in claim 1 wherein the aldehyde - or ketone compound used for the preparation of polyfunctional phenolic compound (1) is selected from the group consisting of salicylaldehyde, p-hydroxybenzaldehyde and p-hydroxy acetophenone.

3. An epoxy resin as claimed in claim 1, wherein the phenol dimethylol compound or the phenol novolak dimethylol compound used for the preparation of polyfunctional phenolic compound (2) is selected from the group consisting of an o-cresol dimethylol compound, a p-cresol dimethylol compound a dimethylolphenol compound and a phenol binuclear dimethylol compound of the general formula (A) 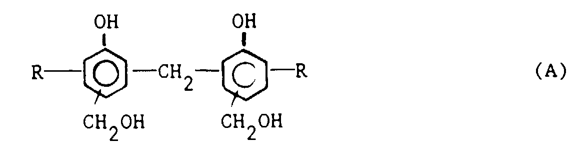 wherein each R is independently H or CH₃.

4. An epoxy resin as claimed in claim 3 wherein the phenol binuclear dimethylol compound is selected from the group consisting of a m-cresol binuclear dimethylol compound, a p-cresol binuclear dimethylol compound and a phenol binuclear dimethylol compound.

5. An epoxy resin as claimed in any one of the claims 1 to 4 wherein the phenolic compound, used for the preparation of each of the polyfunctional phenolic compounds (1), (2) and (3), may each independently be selected from the group consisting of phenol, o-cresol, m-cresol, p-cresol p-(t-butyl)-phenol and bisphenol A.

6. An epoxy resin as claimed in any one of the claims 1 to 5, wherein the glycidyletherification is carried out with epichlorohydrin or epibromohydrin.

7. An epoxy resin as claimed in any one of the claims 1 to 6 which further comprises an other epoxy resin having two or more epoxy groups per molecule in an amount of less than 50% by weight of the total amount of the "epoxy resin a" and this other epoxy resin.

8. An epoxy resin composition comprising an epoxy resin as claimed in any one of the claims 1 to 7, a hardener an accelerator and a solvent.

9. A laminate comprising a composition as claimed in claim 9 applied to a glass cloth and subsequently curing said composition.

## Claims (Claims for the following Contracting State(s): ES)

1. A process for the preparation of an epoxy resin comprising as principal component an "epoxy resin a" which has a polydispersity coefficient, (M_{w}/Mₙ), lower than 2.5, by reaction of:
1. a polyglycidyl-etherified product (I), obtainable by glycidyletherifying a polyfunctional phenolic compound selected from the group consisting of:
(1) a product being obtainable by reacting an aldehyde - or ketone compound having a hydroxyl group substituted phenyl group with a phenolic compound in the presence of an acid catalyst;
(2) a product being obtainable by reacting a phenol dimethylol compound or a phenol novolak dimethylol compound with a phenolic compound in the presence of an acid catalyst; and
(3) a product obtainable by reacting a phenolic compound and formaldehyde in the presence of an acid catalyst, with
2. a difunctional epoxy resin (II), having the skeleton of at least one bisphenol compound selected from the group consisting of bisphenol A, bisphenol F and tetrabromobisphenol A, and with
3. at least one bisphenol compound (III), selected from the group consisting of bisphenol A, bisphenol F and tetrabromobisphenol A.

2. A process as claimed in claim 1 wherein the aldehyde - or ketone compound used for the preparation of polyfunctional phenolic compound (1) is selected from the group consisting of salicylaldehyde, p-hydroxybenzaldehyde and p-hydroxy acetophenone.

3. A process as claimed in claim 1, wherein the phenol dimethylol compound or the phenol novolak dimethylol compound used for the preparation of polyfunctional phenolic compound (2) is selected from the group consisting of an o-cresol dimethylol compound, a p-cresol dimethylol compound a dimethylolphenol compound and a phenol binuclear dimethylol compound of the general formula (A) 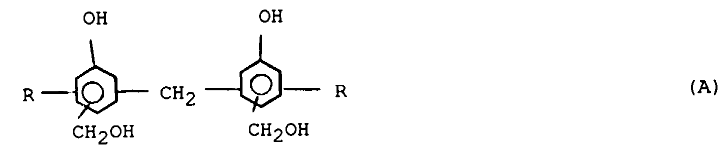 wherein each R is independently H or CH₃.

4. A process as claimed in claim 3 wherein the phenol binuclear dimethylol compound is selected from the group consisting of a m-cresol binuclear dimethylol compound, a p-cresol binuclear dimethylol compound and a phenol binuclear dimethylol compound.

5. A process as claimed in any one of the claims 1 to 4 wherein the phenolic compound, used for the preparation of each of the polyfunctional phenolic compounds (1), (2) and (3), may each independently be selected from the group consisting of phenol, o-cresol, m-cresol, p-cresol p-(t-butyl)-phenol and bisphenol A.

6. A process as claimed in any one of the claims 1 to 5, wherein the glycidyletherification is carried out with epichlorohydrin or epibromohydrin.

7. A process as claimed in any one of the claims 1 to 6 which further comprises the step of combining with the "epoxy resin a" an other epoxy resin having two or more epoxy groups per molecule in an amount of less than 50% by weight of the total amount of the "epoxy resin a" and this other epoxy resin.

8. A process for the preparation of a laminate by applying an epoxy resin composition comprising an epoxy resin as made by a process as claimed in any one of the claims 1 to 7, a hardener an accelerator and a solvent to a glass cloth and subsequently curing said composition.

## Patentansprüche (Patentansprüche für folgende(n) Vertragsstaat(en): AT, NL)

1. Ein Epoxyharz, umfassend als Hauptkomponente ein "Epoxyharz a", das einen Polydispersitätskoeffizienten, (M_{w}/Mₙ), von kleiner als 2,5 aufweist und das erhältlich ist durch Umsetzen von:
1. einem Polyglycidyl-veretherten Produkt (I), erhältlich durch Glycidylverethern einer polyfunktionellen phenolischen Verbindung, die aus der Gruppe ausgewählt ist, die aus:
(1) einem durch Umsetzen einer Aldehyd- oder Ketonverbindung mit einem Gehalt an einer durch Hydroxylgruppe(n) substituierten Phenylgruppe mit einer phenolischen Verbindung in Anwesenheit eines Säurekatalysators erhältlichen Produkt;
(2) einem Produkt, das durch Umsetzen einer Phenol-Dimethylolverbindung oder einer Phenol-Novolak-Dimethylolverbindung mit einer phenolischen Verbindung in Anwesenheit eines Säurekatalysators erhältlich ist; und
(3) einem Produkt, das durch Umsetzen einer phenolischen Verbindung mit Formaldehyd in Anwesenheit eines Säurekatalysators erhältlich ist, besteht, mit
2. einem difunktionellen Epoxyharz (II), das das Skelett von wenigstens einer Bisphenolverbindung, ausgewählt aus der aus Bisphenol A, Bisphenol F und Tetrabrombisphenol A bestehenden Gruppe, aufweist, und mit
3. wenigstens einer Bisphenolverbindung (III), ausgewählt aus der aus Bisphenol A, Bisphenol F und Tetrabrombisphenol A bestehenden Gruppe.

2. Epoxyharz nach Anspruch 1, worin die für die Herstellung der polyfunktionellen phenolischen Verbindung (1) eingesetzte Aldehyd- oder Ketonverbindung aus der aus Salicylaldehyd, p-Hydroxybenzaldehyd und p-Hydroxyacetophenon bestehenden Gruppe ausgewählt ist.

3. Epoxyharz nach Anspruch 1, worin die für die Herstellung der polyfunktionellen phenolischen Verbindung (2) eingesetzte Phenol-Dimethylol-Verbindung oder Phenol-Novolak-Dimethylolverbindung aus der aus einer o-Cresol-Dimethylolverbindung, einer p-Cresol-Dimethylolverbindung, einer Dimethylol-Phenolverbindung und einer zweikernigen Phenol-Dimethylolverbindung der allgemeinen Formel (A) 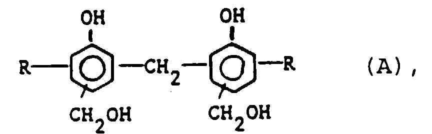 worin jeder Rest R unabhängig H oder CH₃ bedeutet, bestehenden Gruppe ausgewählt ist.

4. Epoxyharz nach Anspruch 3, worin die zweikernige Phenol-Dimethylolverbindung aus der aus einer zweikernigen m-Cresol-Dimethylolverbindung, einer zweikernigen p-Cresol-Dimethylolverbindung und einer zweikernigen Phenol-Dimethylolverbindung bestehenden Gruppe ausgewählt ist.

5. Epoxyharz nach einem der Ansprüche 1 bis 4, worin die für die Herstellung jeder der polyfunktionellen phenolischen Verbindungen (1), (2) und (3) verwendete phenolische Verbindung jeweils unabhängig aus der aus Phenol, o-Cresol, m-Cresol, p-Cresol, p-(ter.Butyl)-phenol und Bisphenol A bestehenden Gruppe ausgewählt sein kann.

6. Epoxyharz nach einem der Ansprüche 1 bis 5, worin die Glycidylveretherung mit Epichlorhydrin oder Epibromhydrin vorgenommen ist.

7. Epoxyharz nach einem der Ansprüche 1 bis 6, welches weiterhin ein anderes Epoxyharz mit zwei oder mehreren Epoxygruppen je Molekül in einer Menge von weniger als 50 Gew.-% der Gesamtmenge aus dem "Epoxyharz a" und diesem anderen Epoxyharz umfaßt.

8. Epoxyharzzusammensetzung, umfassend ein Epoxyharz nach einem der Ansprüche 1 bis 7, einen Härter, einen Beschleuniger und ein Lösungsmittel.

9. Laminat, umfassend eine auf ein Glasgewebe aufgebrachte Zusammensetzung nach Anspruch 8, die anschließend gehärtet worden ist.

## Patentansprüche (Patentansprüche für folgende(n) Vertragsstaat(en): ES)

1. Verfahren zur Herstellung eines Epoxyharzes, umfassend als Hauptkomponente ein "Epoxyharz a", das einen Polydispersitätskoeffizienten, (M_{w}/Mₙ), von kleiner als 2,5 aufweist, durch Umsetzen von:
1. einem Polyglycidyl-veretherten Produkt (I), erhältlich durch Glycidylverethern einer polyfunktionellen phenolischen Verbindung, die aus der Gruppe ausgewählt ist, die aus:
(1) einem durch Umsetzen einer Aldehyd- oder Ketonverbindung mit einem Gehalt an einer durch Hydroxylgruppe(n) substituierten Phenylgruppe mit einer phenolischen Verbindung in Anwesenheit eines Säurekatalysators erhältlichen Produkt;
(2) einem Produkt, das durch Umsetzen einer Phenol-Dimethylolverbindung oder einer Phenol-Novolak-Dimethylolverbindung mit einer phenolischen Verbindung in Anwesenheit eines Säurekatalysators erhältlich ist; und
(3) einem Produkt, das durch Umsetzen einer phenolischen Verbindung mit Formaldehyd in Anwesenheit eines Säurekatalysators erhältlich ist, besteht, mit
2. einem difunktionellen Epoxyharz (II), das das Skelett von wenigstens einer Bisphenolverbindung, ausgewählt aus der aus Bisphenol A, Bisphenol F und Tetrabrombisphenol A bestehenden Gruppe, aufweist, und mit
3. wenigstens einer Bisphenolverbindung (III), ausgewählt aus der aus Bisphenol A, Bisphenol F und Tetrabrombisphenol A bestehenden Gruppe.

2. Verfahren nach Anspruch 1, worin die für die Herstellung der polyfunktionellen phenolischen Verbindung (1) eingesetzte Aldehyd- oder Ketonverbindung aus der aus Salicylaldehyd, p-Hydroxybenzaldehyd und p-Hydroxyacetophenon bestehenden Gruppe ausgewählt ist.

3. Verfahren nach Anspruch 1, worin die für die Herstellung der polyfunktionellen phenolischen Verbindung (2) eingesetzte Phenol-Dimethylol-Verbindung oder Phenol-Novolak-Dimethylolverbindung aus der aus einer o-Cresol-Dimethylolverbindung, einer p-Cresol-Dimethylolverbindung, einer Dimethylol-Phenolverbindung und einer zweikernigen Phenol-Dimethylolverbindung der allgemeinen Formel (A) 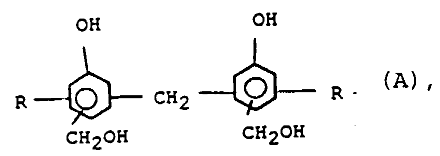 worin jeder Rest R unabhängig H oder CH₃ bedeutet, bestehenden Gruppe ausgewählt ist.

4. Verfahren nach Anspruch 3, worin die zweikernige Phenol-Dimethylolverbindung aus der aus einer zweikernigen m-Cresol-Dimethylolverbindung, einer zweikernigen p-Cresol-Dimethylolverbindung und einer zweikernigen Phenol-Dimethylolverbindung bestehenden Gruppe ausgewählt ist.

5. Verfahren nach einem der Ansprüche 1 bis 4, worin die für die Herstellung jeder der polyfunktionellen phenolischen Verbindungen (1), (2) und (3) verwendete phenolische Verbindung jeweils unabhängig aus der aus Phenol, o-Cresol, m-Cresol, p-Cresol, p-(ter.Butyl)-phenol und Bisphenol A bestehenden Gruppe ausgewählt sein kann.

6. Verfahren nach einem der Ansprüche 1 bis 5, worin die Glycidylveretherung mit Epichlorhydrin oder Epibromhydrin vorgenommen wird.

7. Verfahren nach einem der Ansprüche 1 bis 6, welches weiterhin ein anderes Epoxyharz mit zwei oder mehreren Epoxygruppen je Molekül in einer Menge von weniger als 50 Gew.-% der Gesamtmenge aus dem "Epoxyharz a" und diesem anderen Epoxyharz umfaßt.

8. Verfahren zur Herstellung eines Laminates durch Auftragen einer Epoxyharzzusammensetzung, umfassend ein nach einem Verfahren gemäß einem der Ansprüche 1 bis 7 hergestelltes Epoxyharz, einen Härter, einen Beschleuniger und ein Lösungsmittel, auf ein Glasgewebe und anschließendes Härten dieser Zusammensetzung.

## Revendications (Revendications pour l'(les) Etat(s) contractant(s) suivant(s): AT, NL)

1. Résine époxy comprenant, à titre de constituant principal, une "résine époxy a" qui possède un coefficient de polydispersité, (Mₚ/Mₙ), inférieur à 2,5 et que l'on peut obtenir par la réaction de :
1. un produit polyglycidyl-éthérifié (I), pouvant être obtenu par la glycidyléthérification d'un composé phénolique polyfonctionnel choisi dans le groupe constitué de : (1) un produit pouvant être obtenu par la réaction d'un composé du type aldéhyde ou d'un composé du type cétone possédant un radical phényle substitué par des radicaux hydroxyle avec un composé phénolique, en présence d'un catalyseur acide, (2) un produit pouvant être obtenu par la réaction d'un composé phénoldiméthylolique ou d'un composé phénol-novolaque diméthylolique avec un composé phénolique, en présence d'un catalyseur acide, et (3) un produit pouvant être obtenu par la réaction d'un composé phénolique avec le formaldéhyde, en présence d'un catalyseur acide, avec
2. une résine époxy difonctionnelle (II), possédant le squelette d'au moins un composé du type bisphénol choisi dans le groupe formé par le bisphénol-A, le bisphénol-F et le tétrabromobisphénol-A, et avec
3. au moins un composé du type bisphénol (III), choisi dans le groupe formé par le bisphénol-A, le bisphénol-F et le tétrabromobisphénol A.

2. Résine époxy suivant la revendication 1, caractérisée en ce que le composé d'aldéhyde ou le composé de cétone employé pour la préparation du composé phénolique polyfonctionnel (1) est choisi dans le groupe formé par le salicylaldéhyde, le p-hydroxybenzaldéhyde et la p-hydroxyacétophénone.

3. Résine époxy suivant la revendication 1, caractérisée en ce que le composé de phénol diméthylolé ou le composé de phénol-novolaque diméthylolé utilisé pour la préparation du composé phénolique polyfonctionnel (2) est choisi dans le groupe formé par un composé de o-crésol diméthylolé, un composé de p-crésol diméthylolé, un composé de diméthylolphénol et un composé de phénol binucléaire diméthylolé de la formule générale (A) : 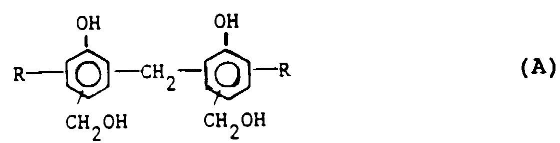 dans laquelle chaque symbole R représente indépendamment H ou CH₃.

4. Résine époxy suivant la revendication 3, caractérisée en ce que le composé de phénol binucléaire diméthylolé est choisi dans le groupe formé par un composé de m-crésol binucléaire diméthylolé, un composé de p-crésol binucléaire diméthylolé et un composé de phénol binucléaire diméthylolé.

5. Résine époxy suivant l'une quelconque des revendications 1 à 4, caractérisée en ce que le composé phénolique, utilisé pour la préparation de chacun des composés phénoliques polyfonctionnels (1), (2) et (3), peut être indépendamment choisi dans le groupe formé par le phénol, le o-crésol, le m-crésol, le p-crésol, le p-(t-butyl)-phénol et le bisphénol-A.

6. Résine époxy suivant l'une quelconque des revendications 1 à 5, caractérisée en ce que l'on entreprend la glycidyléthérification avec l'épichlorhydrine ou l'épibromhydrine.

7. Résine époxy suivant l'une quelconque des revendications 1 à 6, caractérisée en ce qu'elle comprend, en outre, une autre résine époxy possédant deux ou plus de deux radicaux époxy par molécule en une quantité inférieure à 50% en poids de la quantité totale de la "résine époxy a" et de cette autre résine époxy.

8. Composition de résine époxy comprenant une résine époxy telle que définie dans l'une quelconque des revendications 1 à 7, un durcisseur, un accélérateur et un solvant.

9. Stratifié ou lamifié comprenant une composition suivant la revendication 8, appliqué sur un tissu de verre et obtenu en faisant ensuite durcir ladite composition.

## Revendications (Revendications pour l'(les) Etat(s) contractant(s) suivant(s): ES)

1. Procédé de préparation d'une résine époxy comprenant, à titre de composant principal, une "résine époxy a" qui possède un coefficient de polydispersité, (Mₚ/Mₙ), inférieur à 2,5, par la réaction de :
1. un produit polyglycidyl-éthérifié (I), que l'on peut obtenir par la glycidyléthérification d'un composé phénolique polyfonctionnel choisi dans le groupe formé par :
(1) un produit que l'on peut obtenir par la réaction d'un composé d'aldéhyde ou d'un composé de cétone possédant un radical phényle substitué par des radicaux hydroxyle avec un composé phénolique, en présence d'un catalyseur acide;
(2) un produit que l'on peut obtenir par la réaction d'un composé de phénoldiméthylolé ou d'un composé de phénol-novolaque diméthylolé avec un composé phénolique, en présence d'un catalyseur acide, et
(3) un produit que l'on peut obtenir par la réaction d'un composé phénolique et de formaldéhyde, en présence d'un catalyseur acide, avec
2. une résine époxy difonctionnelle (II), possédant le squelette d'au moins un composé bisphénol choisi dans le groupe formé par le bisphénol-A, le bisphénol-F et le tétrabromobisphénol-A, et avec
3. au moins un composé de bisphénol (III), choisi dans le groupe formé par le bisphénol-A, le bisphénol-F et le tétrabromobisphénol A.

2. Procédé suivant la revendication 1, caractérisé en ce que le composé d'aldéhyde ou le composé de cétone utilisé pour la préparation du composé phénolique polyfonctionnel (I) est choisi dans le groupe formé par le salicylaldéhyde, le p-hydroxybenzaldéhyde et la p-hydroxyacétophénone.

3. Procédé suivant la revendication 1, caractérisé en ce que le composé de phénol diméthylolé ou le composé de phénol-novolaque diméthylolé utilisé pour la préparation du composé phénolique polyfonctionnel (2) est choisi dans le groupe formé par un composé de o-crésol diméthylolé, un composé de p-crésol diméthylolé, un composé de diméthylolphénol et un composé de phénol binucléaire diméthylolé de la formule générale (A) : 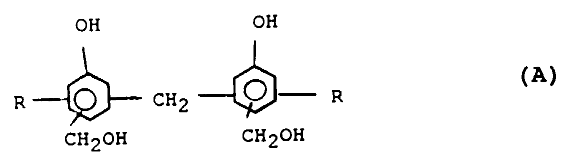 dans laquelle chaque symbole R représente indépendamment H ou CH₃.

4. Procédé suivant la revendication 3, caractérisé en ce que le composé de phénol binucléaire diméthylolé est choisi dans le groupe formé par un composé de m-crésol binucléaire diméthylolé, un composé de p-crésol binucléaire diméthylolé et un composé de phénol binucléaire diméthylolé.

5. Procédé suivant l'une quelconque des revendications 1 à 4, caractérisé en ce que le composé phénolique, utilisé pour la préparation de chacun des composés phénoliques polyfonctionnels (1), (2) et (3), peut être indépendamment choisi dans le groupe formé par le phénol, le o-crésol, le m-crésol, le p-crésol, le p-(t-butyl)-phénol et le bisphénol-A.

6. Procédé suivant l'une quelconque des revendications 1 à 5, caractérisé en ce que l'on entreprend la glycidyléthérification avec l'épichlorhydrine ou l'épibromhydrine.

7. Procédé suivant l'une quelconque des revendications 1 à 6, caractérisé en ce qu'il comprend, en outre, une autre résine époxy possédant deux ou plus de deux radicaux époxy par molécule en une quantité inférieure à 50% en poids de la quantité totale de la "résine époxy a" et de cette autre résine époxy.

8. Procédé de préparation d'un lamifié ou stratifié par l'application d'une composition de résine époxy comprenant une résine époxy telle que préparée par mise un oeuvre d'un procédé suivant l'une quelconque des revendications 1 à 7, d'un durcisseur, d'un accélérateur de solvant sur un tissu de verre et le durcissement subséquent de la composition précitée.
